# EUROPEAN PATENT APPLICATION

(11) **EP 3 396 804 A1**
(43) Date of publication of application: **31.10.2018**
(21) Application number: 18150262.6
(22) Date of filing: 04.01.2018
(51) Int. Cl.: H02H 7/08, H02P 23/26, H02H 7/122

(54) **METHOD AND APPARATUS FOR DETECTING INTER-PHASE SHORT-CIRCUIT OF THREE-PHASE MOTOR AND AIR CONDITIONER INCLUDING THE SAME**

(30) Priority: 09.03.2017 KR 20170030140
(71) Applicant: LG Electronics Inc., Seoul 07336 (KR)
(72) Inventor: JUNG, Yongchan, 08592 Seoul (KR); LEE, Wonwoo, 08592 Seoul (KR)
(74) Representative: Vossius & Partner Patentanwälte Rechtsanwälte mbB

(57) **Abstract**

The present invention relates to inter-phase short-circuit detection, and particularly, to a method and apparatus for detecting inter-phase short-circuit of a three-phase motor, and an air conditioner including the same. The apparatus for detecting inter-phase short-circuit of a three-phase motor according to the present invention includes: a power supply unit for rectifying AC power to supply DC power; an inverter for generating three-phase current for driving the three-phase motor using the DC power, the inverter including a plurality of switching elements including high-side switching elements and low-side switching elements corresponding to three phases, and a current sensor commonly connected to the switching elements; a gate driver for driving the plurality of switching elements; and a controller for controlling the gate driver such that current flowing through the high-side switching elements and current flowing through the low-side switching elements partially short-circuit to sense a quantity of current flowing through the current sensor and determine inter-phase short-circuit.

## Description

This application claims the benefit of Korean Patent Application No. 10-2017-0030140, filed on March 9, 2017.

The present invention relates to inter-phase short-circuit detection, and more particularly, to a method and apparatus for detecting inter-phase short-circuit and an air conditioner including the same.

In general, a compressor of an air conditioner uses a motor as a driving source. Such a motor is provided with AC power from a power converter.

It is known that the aforementioned power converter includes a rectifier, a power factor controller and an inverter.

First, a commercial AC voltage source output from a commercial power supply is rectified by the rectifier. The voltage rectified by the rectifier is supplied to the inverter. The inverter generates a 3-phase AC voltage for driving a motor using the voltage output from the rectifier.

A DC-DC converter for power factor improvement may be provided between the rectifier and the inverter as necessary.

Meanwhile, short-circuit may occur on a current path to the motor through the inverter for various reasons.

Overcurrent may be generated due to such inter-phase short-circuit, and in such a state, very high current instantaneously flows and thus a device may be damaged within a short time.

Accordingly, a method for rapidly and efficiently detecting such an inter-phase short-circuit to perform a protection operation is needed.

An object of the present invention is to provide a method and apparatus for rapidly and efficiently detecting an inter-phase short-circuit in an air conditioner and an air conditioner including the same.

In a first aspect of the present invention to accomplish the aforementioned technical object, an apparatus for detecting inter-phase short-circuit of a three-phase motor as defined in claim 1 includes: a power supply unit for rectifying AC power to supply DC power; an inverter for generating three-phase current for driving the three-phase motor using the DC power, the inverter including a plurality of switching elements including high-side switching elements and low-side switching elements corresponding to three phases, and a current sensor commonly connected to the switching elements; a gate driver for driving the plurality of switching elements; and a controller for controlling the gate driver such that current flowing through the high-side switching elements and current flowing through the low-side switching elements partially short-circuit to sense a quantity of current flowing through the current sensor and determine inter-phase short-circuit.

In a second aspect of the present invention to accomplish the aforementioned technical object, a method as defined in claim 8 for detecting inter-phase short-circuit of an inverter including a plurality of switching elements including high-side switching elements and low-side switching elements corresponding to three phases or a motor driven by three-phase current generated by the inverter includes flowing inverter current such that current flowing through the high-side switching elements and current flowing through the low-side switching elements partially short-circuit; sensing a quantity of the inverter current; and comparing the quantity of the inverter current with a predetermined threshold value to determine inter-phase short-circuit.

### BRIEF DESCRIPTION OF THE DRAWINGS

FIG. 1 is a block diagram of a power converter applicable to the present invention.
FIG. 2 is a circuit diagram of the power converter applicable to the present invention.
FIG. 3 is a circuit diagram illustrating a power converter according to an embodiment of the present invention in detail.
FIG. 4 illustrates paths on which short-circuit may occur in a configuration of connection between the motor and the inverter.
FIG. 5 is a signal diagram illustrating inverter driving signals for determining inter-phase short-circuit according to a first embodiment of the present invention.
FIG. 6 is a signal flow diagram illustrating an inverter driving signal for determining inter-phase short-circuit according to the first embodiment of the present invention.
FIG. 7 is a signal diagram illustrating inverter driving signals for determining inter-phase short-circuit according to a second embodiment of the present invention.
FIG. 8 is a signal flow diagram illustrating an inverter driving signal for determining inter-phase short-circuit according to the second embodiment of the present invention.

### DETAILED DESCRIPTION OF THE INVENTION

Embodiments of the present invention will be described below with reference to the attached drawings.

While the invention is susceptible to various modifications and alternative forms, specific embodiments thereof are shown by way of example in the drawings and will herein be described in detail. It should be understood, however, that there is no intent to limit the invention to the particular forms disclosed, but on the contrary, the invention is to cover all modifications, equivalents, and alternatives falling within the spirit and scope of the invention as defined by the claims.

It will be understood that when an element is referred to as being "on" another element, it can be directly on the other element or intervening elements may be present therebetween.

It will be understood that, although the terms first, second, third etc. may be used herein to describe various elements, components, regions, layers and/or sections, these elements, components, regions, layers and/or sections should not be limited by these terms.

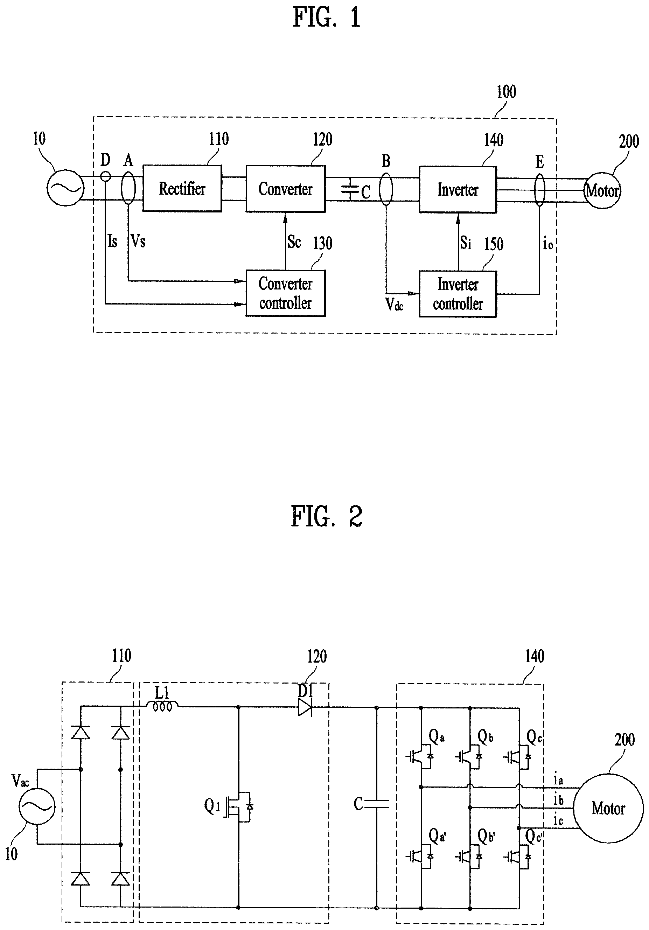

FIG. 1 is a block diagram of a power converter applicable to the present invention and FIG. 2 is a circuit diagram of the power converter applicable to the present invention.

Referring to FIGS. 1 and 2, a power converter 100 may include a rectifier 110 for rectifying AC power 10, a converter 120 for boosting/dropping a DC voltage rectified by the rectifier 110 or controlling a power factor, a converter controller 130 for controlling the converter 120, an inverter 140 outputting a three-phase AC, an inverter controller 150 for controlling the inverter 140, and a DC-link capacitor C provided between the converter 120 and the inverter 140.

The inverter 140 outputs a three-phase AC to a motor 200. Here, the motor 200 may be a compressor motor which drives an air conditioner. Hereinafter, an example in which the motor 200 is a compressor motor which drives an air conditioner and the power converter 100 is a motor driver for driving the compressor motor will be described. Accordingly, the motor driver will be described with the same reference numeral as the power converter 100.

However, the motor 200 is not limited to the compressor motor and can be used in various applications using a frequency-varied AC voltage, for example, AC motors of refrigerators, washing machines, electric vehicles, vehicles, cleaners, etc.

The motor driver 100 may further include a DC-link voltage detector B, an input voltage detector A, an input current detector D and an output current detector E.

The motor driver 100 is provided with AC power from a system, converts the AC power and supplies the converter power to the motor 200.

The converter 120 converts the input AC power 10 into DC power. A DC-DC converter operating as a power factor controller (PFC) may be used as the converter 120. In addition, such a DC-DC converter may use a boost converter. The converter 120 may include the rectifier 110 as necessary. Hereinafter, an example in which a boost converter is used as the converter 120 will be described.

The rectifier 110 is provided with the single-phase AC power 10, rectifies the single-phase AC power 10 and outputs the rectified power to the converter 120. To this end, the rectifier 110 may use a full-wave rectifier using a bridge diode.

The converter 120 can perform power factor improvement in a process of boosting and smoothing the voltage rectified by the rectifier 110.

The converter 120 may include an inductor L1 connected to the rectifier 110, a switching element Q1 connected to the inductor L1, a capacitor C connected in parallel with the switching element Q1, and a diode D1 connected between the switching element Q1 and the DC-link capacitor C.

The boost converter 120 is a converter capable of acquiring an output voltage higher than an input voltage, in which the diode D1 is cut off and thus energy is stored in the inductor L1 and charges stored in the DC-link capacitor C are discharged to generate an output voltage at the output port when the switching element Q1 is turned on.

In addition, when the switching element Q1 is cut off, energy stored in the inductor L1 while the switching element Q1 is turned on is added and delivered to the output port.

Here, the switching element Q1 can perform a switching operation according to a separate pulse width modulation (PWM) signal. That is, a PWM signal delivered from the converter controller 130 is applied to the gate (or base) of the switching element Q1 and thus the switching element Q1 can perform a switching operation according to the PWM signal.

The converter controller 130 may include a gate driver which delivers a PWM signal to the gate of the switching element Q1 and a controller which delivers a driving signal to the gate driver.

The switching element Q1 may use a power transistor, for example, an insulated gate bipolar mode transistor (IGBT).

An IGBT is a switching element having the structures of a metal oxide semiconductor field effect transistor (MOSFET) and a bipolar transistor and can achieve low driving power, fast switching, high breakdown voltage and high current density.

In this manner, the converter controller 130 can control turn-on timing of the switching element Q1 included in the converter 120. Accordingly, the converter controller 130 can output a converter control signal Sc for turn-on timing of the switching element Q1.

To this end, the converter controller 130 may receive an input voltage Vs and an input current Is from the input voltage detector A and the input current detector D, respectively.

The converter 120 and the converter controller 130 may be omitted as necessary. That is, the output voltage which has passed through the rectifier 110 may be stored in the DC-link capacitor C or may drive the inverter 120 without passing through the converter 120.

The input voltage detector A can detect the input voltage Vs from the input AC power 10. For example, the input voltage detector A may be located before the rectifier 110.

The input voltage detector A may include a resistor, an operational amplifier, and the like for voltage detection. The detected input voltage Vs is a discrete signal taking a pulse form and may be applied to the converter controller 130 in order to generate the converter control signal Sc.

The input current detector D can detect the input current Is from the input AC power 10. Specifically, the input current detector D can be located before the rectifier 110.

The input current detector D may include a current sensor, a current transformer (CT), a shunt resistor, and the like for current detection. The detected input voltage Is is a discrete signal taking a pulse form and may be applied to the converter controller 130 in order to generate the converter control signal Sc.

The DC voltage detector B detects a pulsating voltage Vdc of the DC-link capacitor C. For such voltage detection, a resistor, an operational amplifier and the like may be used. The detected voltage Vdc of the DC-link capacitor C is a discrete signal taking a pulse form and may be applied to the inverter controller 150, and an inverter control signal Si can be generated on the basis of the DC voltage Vdc of the DC-link capacitor C.

Alternatively, the detected DC voltage may be applied to the converter controller 130 and used to generate the converter control signal Sc, differently from the figure.

The inverter 140 may include a plurality of inverter switching elements Qa, Qb, Qc, Qa', Qb' and Qc', convert the DC voltage Vdc smoothed according to on/off operation of the switching element into a three-phase AC voltage having a predetermined frequency and output the three-phase AC power to the three-phase motor 200.

Specifically, in the inverter 140, high-side switching elements Qa, Qb and Qc and low-side switching elements Qa', Qb' and Qc' respectively connected to the high-side switching elements Qa, Qb and Qc may be paired and three pairs of high-side and low-side switching elements may be connected in parallel.

Like the converter 120, a power transistor, for example, an IGBT, may be used as the switching elements Qa, Qb, Qc, Qa', Qb' and Qc' of the inverter.

The inverter controller 150 may output the inverter control signal Si to the inverter 140 in order to control the switching operation of the inverter 140. The inverter control signal Si is a PWM switching control signal which may be generated on the basis of an output current io flowing to the motor 200 and the DC-link voltage Vdc across the DC-link capacitor C and output. Here, the output current io may be detected from the output current detector E and the DC-link voltage Vdc may be detected from the DC-link voltage detector B.

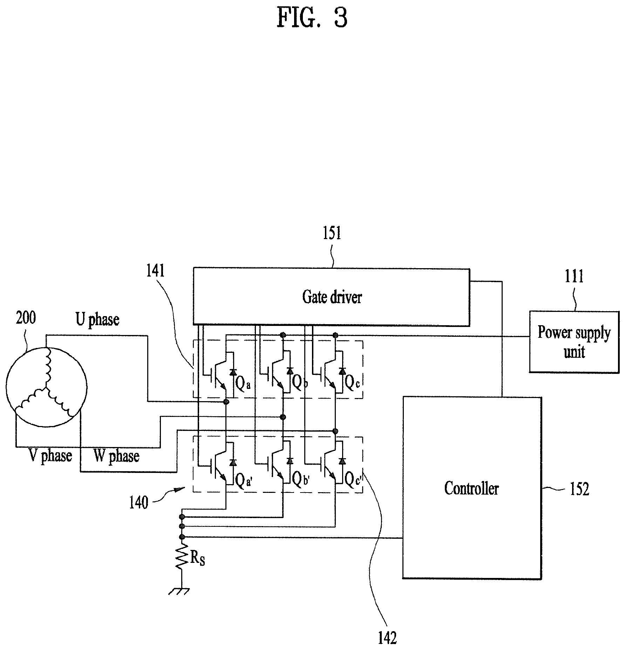

The inverter controller 150 may include a gate driver 151 (refer to FIG. 3) which delivers a PWM signal to the gates of the switching elements Qa, Qb, Qc, Qa', Qb' and Qc' included in the inverter 140 and a controller 152 which delivers a driving signal to the gate driver 151.

The output current detector E can detect the output current io flowing between the inverter 140 and the motor 200. That is, the output current detector E detects a current flowing through the motor 200. The output current detector E can detect all output currents ia, ib and ic of respective phases or may detect output currents of two phases using three-phase balancing.

The output current detector E may be located between the inverter 140 and the motor 200 and may use a current transformer (CT), a shunt resistor or the like for current detection.

FIG. 3 is a circuit diagram illustrating a power converter according to an embodiment of the present invention in detail.

The power converter 100 for driving the motor 200 described above with reference to FIGS. 1 and 2 is briefly illustrated in FIG. 3.

The configuration including the rectifier 110 connected to the AC power 10, the DC-link capacitor C and the converter 120, shown in FIGS. 1 and 2, is represented as a power supply unit 111 in FIG. 3. Here, the power supply unit 111 may include only the rectifier 110 and the DC-link capacitor C.

In addition, the switching elements of the inverter 140 are illustrated as being divided into a high-side switching element group 141 and a low-side switching element group 142.

Here, each switching element is connected to a current sensor Rs which may be implemented as a shunt resistor. That is, current applied to the shunt resistor Rs, which is a product of current and resistance according to Ohm's law, is converted into a voltage signal and applied to the controller 152.

As described above, the inverter controller 150 may include the gate driver 151 which transfers a PWM signal to the gates of the switching elements Qa, Qb, Qc, Qa', Qb' and Qc' included in the inverter 140 and the controller 152 which transfers a driving signal to the gate driver 151.

That is, the gate driver 151 supplies an on/off (or high/low) signal to the gates of the switching elements included in the high-side switching element group 141 and the low-side switching element group 142 to control on/off of the switching elements.

Here, the controller 152 can control the gate driver 151 by transferring a driving signal such as a PWM signal to the gate driver 151.

The details described with reference to FIGS. 1 and 2 can be applied to a part which is not described in FIG. 3. Redundant description will be omitted in the following.

The inverter 140 generates three-phase AC power and provides the same to the motor 200. The three-phase AC power can be represented as a U phase, a V phase and a W phase, as illustrated in FIG. 3. The three-phase power may be represented as a first phase, a second phase and a third phase as necessary. Here, the first phase, the second phase and the third phase may refer to the U phase, the V phase and the W phase, respectively, but they may refer to different phases. That is, the first phase, the second phase and the third phase may respectively correspond to the W phase, the U phase and the V phase as necessary.

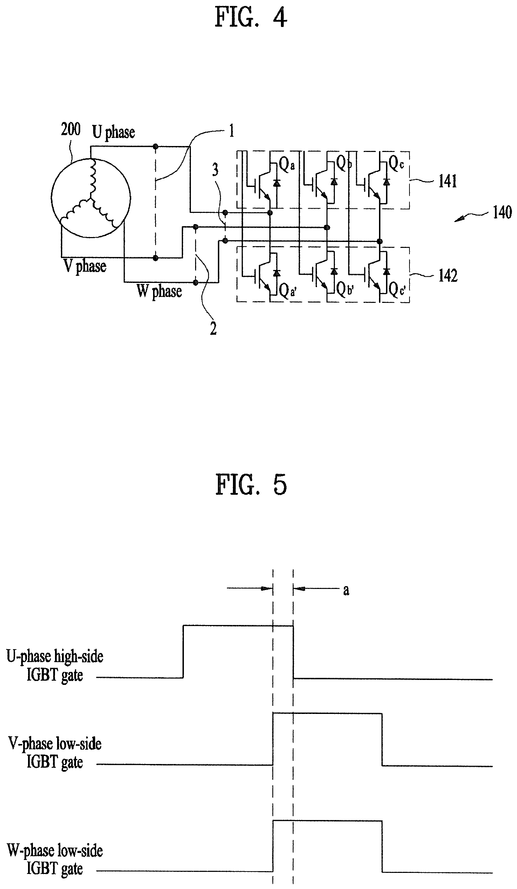

FIG. 4 illustrates paths on which short-circuit may occur in a configuration of connection between the motor and the inverter.

Referring to FIG. 4, short-circuit may occur on a path 1 between the U phase and the V phase, a path 2 between the V phase and the W phase and a path 3 between the W phase and the U phase among paths between the motor 200 and the inverter 140.

For example, when current flows from the first switching element Qa of the high-side switching element group 141, which corresponds to the U phase, the current can pass through the short-circuit path 1 between the U phase and the V phase when flowing to the V phase through the motor 200 and pass through the short-circuit path 3 between the U phase and the W phase when flowing to the W phase through the motor 200.

When current flows from the second switching element Qb or the third switching element Qc of the high-side switching element group 141, which corresponds to the V phase or the W phase, the current can pass through the remaining short-circuit path 2 (between the V phase and the W phase).

Consequently, to check short-circuit on the three paths, a signal is applied to different switching elements twice.

In this manner, the gate driver 151 is controlled such that current flowing through the high-side switching elements and current flowing through the low-side switching elements partially short-circuit, the current sensor Rs senses the quantity of flowing current at that moment, and the controller 152 determines inter-phase short-circuit.

That is, current is controlled to partially short-circuit while passing through the short-circuit paths 1, 2 and 3, as described above, and the quantity of current at that moment is sensed to determine inter-phase short-circuit.

Hereinafter, the method and configuration for determining inter-phase short-circuit will be described in detail with reference to the drawings.

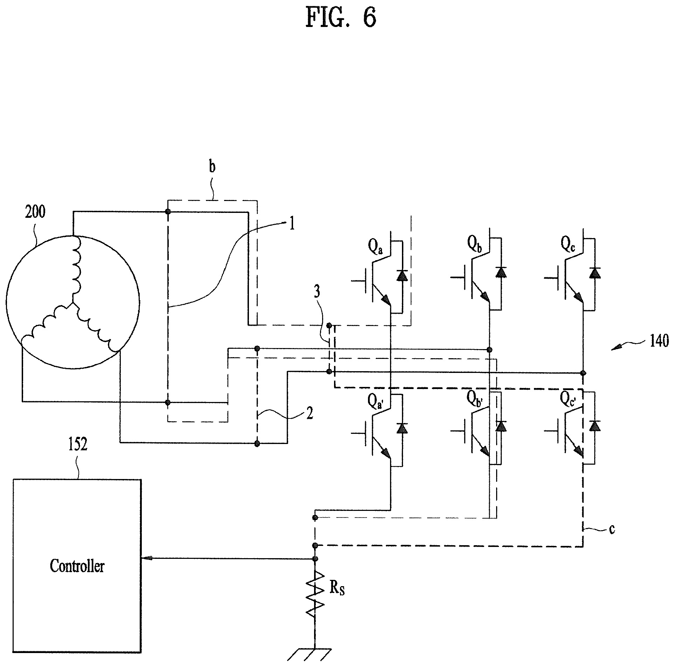

FIG. 5 is a signal diagram illustrating inverter driving signals for determining inter-phase short-circuit according to a first embodiment of the present invention. FIG. 6 is a signal flow diagram illustrating an inverter driving signal for determining inter-phase short-circuit according to the first embodiment of the present invention.

Referring to FIGS. 5 and 6, the controller 152 may turn on the high-side switching element (IGBT) Qa corresponding to the U phase among the three phases and control the gate driver 151 such that ON time of the low-side switching elements (IGBT) Qb' and Qc' corresponding to the V phase and the W phase overlaps with ON time of the high-side switching element Qa for a first time a to determine whether short-circuit occurs on the short-circuit path 1 between the U phase and the V phase and the short-circuit path 3 between the U phase and the W phase.

Referring to FIG. 6, current flowing from the high-side switching element Qa corresponding to the U phase among the three phases can pass through the short-circuit path 1 between the U phase and the V phase and the low-side switching element Qb' corresponding to the V phase and reach the shunt resistor Rs.

In addition, current flowing from the high-side switching element Qa corresponding to the U phase among the three phases can pass through the short-circuit path 3 between the U phase and the W phase and the low-side switching element Qc' corresponding to the W phase and reach the shunt resistor Rs.

In this manner, the inverter can be driven such that a time for which gate on signals of the high side and the low side overlap is short to allow current to flow only for a minimum time for determining short-circuit.

Here, all currents pass through the shunt resistor Rs. Here, a voltage value applied to the shunt resistor Rs is transferred through an input port pin of the controller 152 implemented as a semiconductor integrated circuit (IC), such as a microcomputer.

Then, the controller 152 can determine short-circuit by comparing the voltage value applied to the shunt resistor Rs with a predetermined threshold voltage value.

Here, the first time may be a minimum duration of a pulse signal which can be generated by the controller 52. That is, the first time may be a duration of a shortest pulse signal which can be generated by a microcomputer such as a semiconductor IC.

The duration of such a pulse signal may be 10 to 20 µs. However, a minimum duration of such a pulse signal may vary according to the performance of the IC (microcomputer) which implements the controller 152.

It is available to determine whether short-circuit between two of the three phases occurs by driving the inverter 140 as described above.

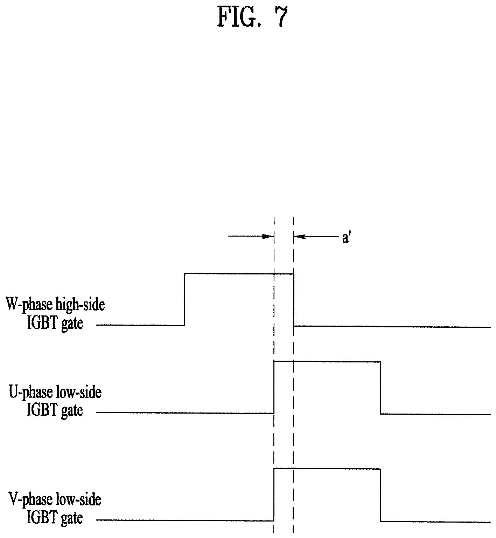

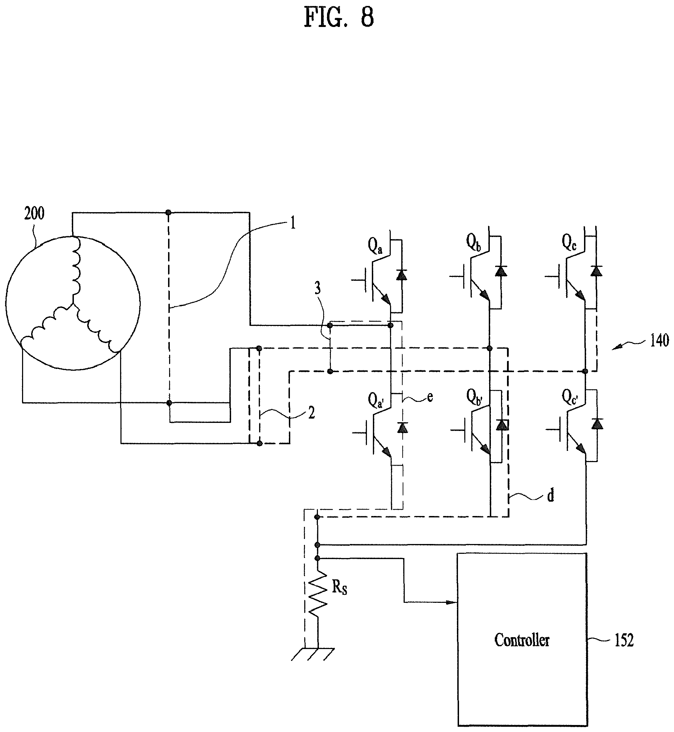

FIG. 7 is a signal diagram illustrating inverter driving signals for determining inter-phase short-circuit according to a second embodiment of the present invention. FIG. 8 is a signal flow diagram illustrating an inverter driving signal for determining inter-phase short-circuit according to the second embodiment of the present invention.

Referring to FIGS. 7 and 8, the controller 152 may control the gate driver 151 such that ON time of the high-side switching element Qc corresponding to the W phase among the three phases overlaps with ON time of the low-side switching elements Qa' and Qb' corresponding to the U phase and the V phase for a second time a'.

Referring to FIG. 8, current flowing from the high-side switching element Qc corresponding to the W phase among the three phases can pass through the short-circuit path 3 between the U phase and the W phase and the low-side switching element Qa' corresponding to the U phase and reach the shunt resistor Rs.

In addition, current flowing from the high-side switching element Qc corresponding to the W phase among the three phases can pass through the short-circuit path 2 between the V phase and the W phase and the low-side switching element Qb' corresponding to the V phase and reach the shunt resistor Rs.

In this manner, the inverter can be driven such that a time for which gate on signals of the high side and the low side overlap is short to allow current to flow only for a minimum time for determining short-circuit.

Here, all currents pass through the shunt resistor Rs. Here, a voltage value applied to the shunt resistor Rs is transferred through an input port pin of the controller 152 implemented as a semiconductor integrated circuit (IC), such as a microcomputer.

Then, the controller 152 can determine short-circuit by comparing the voltage value applied to the shunt resistor Rs with a predetermined threshold voltage value.

Here, the second time a' may be a minimum duration of a pulse signal which can be generated by the controller. Furthermore, the second time a' may be the same as the aforementioned first time a. The description of the first time a in the aforementioned first embodiment can be equally applied to the second time a'.

As described above, it is possible to determine whether short-circuit occurs on the short-circuit path 1 between the U phase and the V phase and the short-circuit 3 between the U phase and the W phase according to circuit operation of the first embodiment.

Furthermore, it is possible to determine whether short-circuit occurs on the short-circuit path 3 between the U phase and the W phase and the short-circuit 2 between the V phase and the W phase according to circuit operation of the second embodiment.

Therefore, it is available to determine whether short-circuit occurs on all of the short-circuit paths 1, 2 and 3 according to such two operations.

As necessary, the gate driver 151 may be controlled such that the ON time of the high-side switching element Qb corresponding to the V phase among the three phases overlaps with the ON time of the low-side switching elements Qa' and Qc' corresponding to the U phase and the W phase for the second time a' in the second embodiment.

Inter-phase short-circuit determination as described above may be performed according to control of the controller 152 before the motor 200 is started. That is, inter-phase short-circuit determination can be performed prior to normal operation of an air conditioner equipped with the motor 200 and the power converter 100.

Accordingly, protection operation can be performed depending on whether inter-phase short-circuit occurs. For example, whether short-circuit has occurred may be displayed such that normal operation of the air conditioner is not performed, or a path on which short-circuit has occurred may be displayed as necessary.

As described above, it is available to determine occurrence of short-circuit by short-circuiting part of inverter circuit paths for a very short time to prevent device damage due to instantaneous overcurrent.

That is, according to the present invention, it is available to determine an inter-phase short-circuit state prior to operation using only a gate driving signal of switching elements which form the inverter. Accordingly, a possibility of device damage due to inter-phase short-circuit can be minimized. Such inter-phase short-circuit determination can be performed only by controlling operation of the gate driver by the controller without an additional circuit configuration.

Those skilled in the art will appreciate that the present invention may be carried out in other specific ways than those set forth herein without departing from the essential characteristics of the present invention. The above embodiments are therefore to be construed in all aspects as illustrative and not restrictive. The scope of the invention should be determined by the appended claims, not by the above description, and all changes coming within the meaning of the appended claims are intended to be embraced therein.

## Claims

1. An apparatus for detecting inter-phase short-circuit of a three-phase motor, comprising:
a power supply unit (111) for rectifying AC power to supply DC power;
an inverter (140) for generating three-phase current for driving the three-phase motor using the DC power, the inverter (140) including a plurality of switching elements (Qa, Qb, Qc, Qa', Qb' and Qc') including high-side switching elements (Qa, Qb and Qc) and low-side switching elements (Qa', Qb' and Qc') corresponding to three phases, and a current sensor (Rs) commonly connected to the switching elements;
a gate driver (151) for driving the plurality of switching elements (Qa, Qb, Qc, Qa', Qb' and Qc'); and
a controller (152) for controlling the gate driver (151) such that current flowing through the high-side switching elements (Qa', Qb' and Qc') and current flowing through the low-side switching elements (Qa', Qb' and Qc') partially short-circuit to sense a quantity of current flowing through the current sensor (Rs) and determine inter-phase short-circuit.

2. The apparatus according to claim 1, wherein the controller (152) controls the gate driver (151) such that ON time of a high-side switching element corresponding to a first phase of the three phases overlaps with ON time of low-side switching elements corresponding to second and third phases for a first time.

3. The apparatus according to claim 2, wherein the controller (152) additionally controls the gate driver (151) such that ON time of the high-side switching element corresponding to the third phase of the three phases overlaps with ON time of the low-side switching elements corresponding to the first and second phases for a second time.

4. The apparatus according to claim 3, wherein the first time is the same as the second time.

5. The apparatus according to claim 3 or 4, wherein the controller (152) is implemented as a semiconductor integrated circuit (IC) and the first time and the second time correspond to a minimum duration of a pulse signal generated by the semiconductor IC.

6. The apparatus according to claim 5, wherein the minimum duration is 10 to 20 µs.

7. The apparatus according to any one of claims 1 to 6, wherein the controller (152) determines inter-phase short-circuit by comparing the quantity of current flowing through the current sensor with a predetermined threshold value.

8. A method for detecting inter-phase short-circuit of an inverter (140) including a plurality of switching elements (Qa, Qb, Qc, Qa', Qb' and Qc') including high-side switching elements (Qa, Qb and Qc) and low-side switching elements (Qa', Qb' and Qc') corresponding to three phases or a motor (200) driven by three-phase current generated by the inverter (140), comprising:
flowing inverter current such that current flowing through the high-side switching elements (Qa, Qb and Qc) and current flowing through the low-side switching elements (Qa', Qb' and Qc') partially short-circuit;
sensing a quantity of the inverter current; and
comparing the quantity of the inverter current with a predetermined threshold value to determine inter-phase short-circuit.

9. The method according to claim 8, wherein the flowing of the inverter current comprises flowing inverter current such that ON time of a high-side switching element corresponding to a first phase of the three phases overlaps with ON time of low-side switching elements corresponding to second and third phases for a first time.

10. The method according to claim 9, wherein the flowing of the inverter comprises flowing inverter current such that ON time of the high-side switching element corresponding to the third phase of the three phases overlaps with ON time of the low-side switching elements corresponding to the first and second phases for a second time.

11. The method according to claim 10, wherein the first time is the same as the second time.

12. The method according to claim 10 or 11, wherein the first time and the second time correspond to a minimum duration of a pulse signal generated by a semiconductor IC in which the method is implemented.

13. The method according to claim 12, wherein the minimum duration is 10 to 20 µs.

14. The method according to any one of claims 8 to 13, further comprising determining inter-phase short-circuit by comparing the quantity of the inverter current with a predetermined threshold value.
